# EUROPEAN PATENT SPECIFICATION

(11) **EP 1 973 696 B1**
(45) Date of publication and mention of the grant of the patent: **28.09.2011**
(21) Application number: 06832375.7
(22) Date of filing: 29.12.2006
(51) Int. Cl.: B23Q 39/02, B28D 5/02, H05K 3/00

(54) **DRILLING DEVICE**
BOHRVORRICHTUNG
DISPOSITIF DE PERÇAGE

(30) Priority: 03.01.2006 IT PD20060002
(43) Date of publication of application: 01.10.2008
(73) Proprietor: LG Technologies S.R.L., 32013 Longarone (IT)
(72) Inventor: BUSATTA, Gioachino, I-36061 Bassano Del Grappa (VI) (IT)
(74) Representative: Cantaluppi, Stefano
(86) International application number: PCT/IT2006/000887
(87) International publication number: WO 2007/077589

(56) References cited:
- EP-A- 1 452 269
- DE-A1- 19 717 255

## Description

The present invention relates to a drilling device for printed circuit boards

### Technological background

Drilling device are known from DE19717255 or also form EP1452269.

In the manufacture of printed circuit boards it is necessary to provide each board with a large number of holes at the location of at least some of the zones of welding of the circuit components. These holes are obtained by drill heads adapted to drive special drill bits in rotation at high speed. The head is normally displaced along a drilling axis (axis Z) while the positioning movement of the board to be drilled is managed in a drilling plane substantially perpendicular to the drilling axis.

Each drill head therefore carries out a cutting movement towards the drilling plane and through the thickness of the board to be drilled, and a return movement during which it moves away from the drilling plane to allow the board to be drilled to be repositioned.

It is logical that the return movement is intrinsically non-productive and even though it may take place at a relatively high speed, it is still detrimental to the drilling performance of the device.

### Description of the invention

The problem addressed by the present invention is that of providing a drilling device which is structurally and functionally designed to provide better overall performance.

In the context of this problem, an object of the invention is to provide a drilling device of simple and at the same time efficient design enabling the return movement phase to be made productive for the purposes of the drilling operation.

This problem and this object are resolved by the invention which relates to a drilling device embodied in accordance with the accompanying claims.

### Brief description of the drawings

The characteristic features and advantages of the invention are set out in further detail in the following description of a preferred, but not exclusive, embodiment illustrated, by way of non-limiting example, in the accompanying drawings, in which:
Fig. 1 is a perspective view of a device for drilling printed circuit boards and the like according to the present invention;

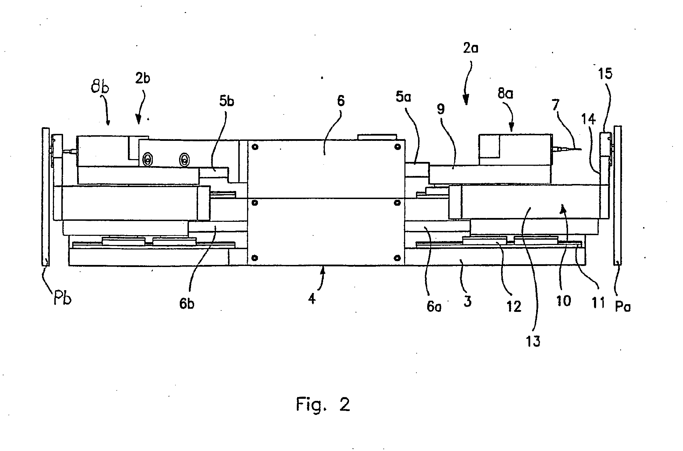

Fig. 2 is a front view of the device of Fig. 1.

### Preferred embodiment of the invention

In the drawings, a device for the high-speed drilling of printed circuit boards and the like according to the present invention is shown overall by 1. The device comprises a first and second drilling unit 2a,b, mounted on the same support 3 and disposed symmetrically opposite one another. Both units are actuated by the same actuator member 4 disposed centrally between them on the support 3. The actuator member 4 comprises a linear actuator 6 with a dual projecting rod, each rod section 5a,b acting on the respective unit 2a,b in the manner described below, and two independently actuated ball screws 6a,b.

The two drilling units 2a,b are identical and only one will therefore be described in detail, the same description and reference numerals applying to both units unless otherwise specified.

Each unit 2a,b comprises a respective drill head 8a,b. Each drill head 8a,b bears a high-speed mandrel on which a drill bit 7 is mounted. Each head 8a,b is also guided along a drilling axis Z by means of a carriage 9 mounted to slide on the support 3 and on which the respective rod section 5a,b of the actuator member 4 acts. Each unit 2a,b further comprises a workpiece pressing device 10 slidebly mounted on the support 3 by means of a guide 11 and respective shoes 12. The workpiece pressing device 10 in turn comprises a piezoelectric actuator 13 acting on an arm 14 which may be resiliently oscillated under the action of the actuator 13. A free end of the arm 14 bears a pressure member 15 of self-aligning type.

The workpiece pressing device is moved along the guide 11 in a direction parallel to the axis Z by means of the respective independently actuated screw 6a,b.

The head 8a,b of each unit 2a,b is displaced, by means of the actuator member 4, towards and away from a respective first and second drilling plane shown diagrammatically by their respective Cartesian axes (XY)a and (XY)b. The drilling planes (XY)a,b are parallel, substantially perpendicular to the axis Z and face the corresponding drill head 8a,b of each unit 2a,b.

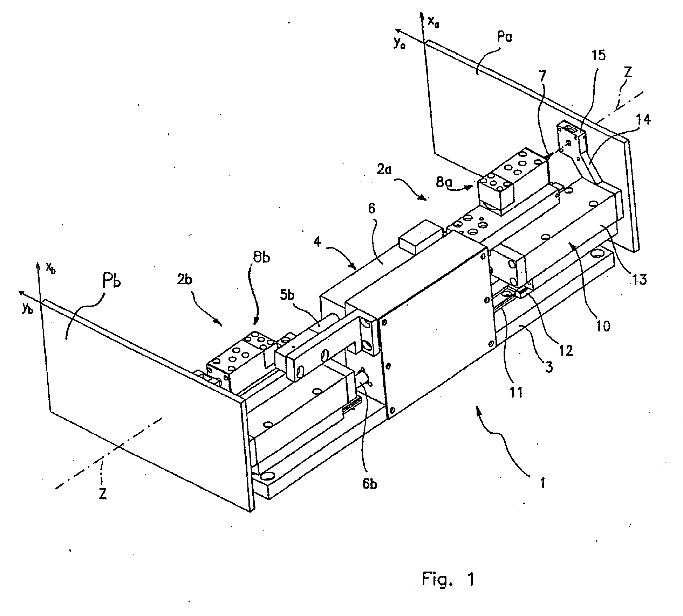

The corresponding boards to be drilled Pa,b, shown in Fig. 1, are mounted on the respective planes (XY)a,b. The boards Pa,b may be displaced during a positioning movement along the corresponding axes (XY)a,b by known actuators, which are not shown. During the positioning movement, the board Pa,b is positioned such that the drill bit 7 faces one of the welding zones of the circuit components. The board Pa,b is pressed against the drilling plane (XY)a,b by the arm 14 of the respective workpiece pressing device 10 during drilling by means of the bit 7 of the corresponding drill head 8a,b. The head 8a,b is independent from the corresponding workpiece pressing device 10, during the movement towards and away from the corresponding drilling plane (XY)a,b.

The drilling device 1 is actuated by means of a computerised digital control, which does not form part of the subject matter of the invention, during the following operating cycle.

The first operation prior to the phase of drilling of the board Pa,b is that of determining the so-called "circuit-plane" position so that the control learns for which coordinates the head 8a,b and the respective workpiece pressing device 10 are physically in a predetermined position with respect to the board Pa,b.

For this first operation, the workpiece pressing device 10 is moved along the guide 11 in a direction parallel to the axis Z by means of the respective screw 6a,b until it touches the board Pa,b with a predetermined contact pressure. The operation is repeated for the other workpiece pressing device.

Each workpiece pressing device 10 is then actuated towards and away from the board Pa, Pb by the piezoelectric actuator 13, whose action is adjusted by varying the frequency at which it is supplied. This frequency variation corresponds to the same frequency variation of the cycle of pressure and raising of the arm 14 and therefore of the pressure member 15 which alternates between a position pressed against the board Pa,b and a position raised therefrom. The frequency of supply of the actuator 13 is thus adjusted to coincide with the frequency of the drilling cycle carried out by means of the drill bit 7 of the drilling head 8a,b.

The drilling head 8a performs a cutting movement along the axis Z and by means of the linear actuator, during which it is displaced towards the drilling plane (XY)a and through the thickness of the board to be drilled Pa. The hole is obtained by driving the drill bit 7 in rotation at high speed.

The head 8a then performs a return movement along the axis Z during which it moves away from the drilling plane (XY)a to enable the new positioning of the board to be drilled. The drill heads of each unit 2a,b are coaxial and rigid in movement along the drilling axis and, therefore, the return movement of the head 8a from the first drilling plane (XY)a corresponds to the positioning in the second drilling plane (XY)b of the head 8b which faces it. The arrangement of the plane (XY)b and the positioning of a second board Pb to be drilled on this plane make it possible to use the return movement of the first head as a cutting movement of the second head and vice versa.

The invention thus resolves the problem set out above and has many advantages with respect to the technical solutions known up to now, including increased productivity with respect to the axis Z which is in practice doubled, and a reduction of costs with respect to standard drilling of two circuits.

## Claims

1. A printed circuit boards (Pa,Pb) drilling device comprising a first drill head (8a) guided along a drilling axis (Z) towards and away from a corresponding first drilling plane ((XY)a) substantially perpendicular to said drilling axis (Z), said drilling plane ((XY)a) being displaceable with respect to said drilling axis (Z) when said first drill head (8a) is moved away from said drilling plane ((XY)a) during a positioning movement of the board to be drilled (Pa), said head (8a) being displaceable along said axis (Z) towards said plane ((XY)a) during a cutting movement and during an opposite return movement from said plane ((XY)a), and further comprising a second drill head (8b) rigid with said first head (8a) in the movement along said axis (Z) and a second drilling plane ((XY)b) parallel to said first plane and facing said second drill head (8b) in an arrangement such that a return movement of said first head (8a) corresponds to a cutting movement of said second head (8b) and vice versa.

2. A drilling device according to claim 1, wherein said drill heads (8a, 8b) are coaxial.

3. A drilling device according to claim 1 or 2, wherein for each drill head a workpiece pressing device (10) is provided, said heads being displaceable towards and away from the corresponding drilling plane ((XY)a,b) independently from the respective workpiece pressing device (10).

4. A drilling device according to one or more of the preceding claims, wherein said drill heads (8a,b) are both actuated by the same actuator (4).

5. A drilling device according to claim 4, wherein said actuator (4) comprises a linear actuator (6) with a dual projecting rod with each rod section (5a,b) acting on the respective drill head (8a,b) so as to actuate one of said heads (8a,b) to perform the cutting movement and at the same time to actuate the other head to perform the return movement.

## Patentansprüche

1. Bohrvorrichtung für gedruckte Leiterplatten (Pa, Pb), umfassend einen ersten Bohrkopf (8a), der entlang einer Bohrachse (Z) zu einer zugeordneten ersten Bohrebene ((XY)a), die im Wesentlichen senkrecht zu dieser Bohrachse (Z) liegt, hin und von dieser weg geführt ist, wobei die Bohrebene ((XY)a) in Bezug auf die Bohrachse (Z) verschiebbar ist, wenn der erste Bohrkopf (8a) bei einer Positionierungsbewegung der zu bohrenden Platte (Pa) von der Bohrebene ((XY)a) weg bewegt wird, wobei der Kopf (8a) bei einer Schneidbewegung und bei einer entgegengesetzten Rückzugsbewegung von der Ebene ((XY)a) entlang der Achse (Z) zu der Ebene ((XY)a) hin verschiebbar ist, und weiter umfassend einen zweiten Bohrkopf (8b), der bei der Bewegung entlang der Achse (Z) mit dem ersten Kopf (8a) starr ist, und eine zweite Bohrebene ((XY)b) parallel zu der ersten Ebene und dem zweiten Bohrkopf (8b) zugewandt in einer solchen Anordnung, dass eine Rückzugsbewegung des ersten Kopfes (8a) einer Schneidbewegung des zweiten Kopfes (8b) zugeordnet ist und umgekehrt.

2. Bohrvorrichtung nach Anspruch 1, wobei die Bohrköpfe (8a, 8b) koaxial ausgebildet sind.

3. Bohrvorrichtung nach Anspruch 1 oder 2, wobei für jeden Bohrkopf eine Werkstückanpressvorrichtung (10) vorgesehen ist, wobei die Köpfe unabhängig von der zugehörigen Werkstückanpressvorrichtung (10) zu der zugeordneten Bohrebene ((XY)a, b) hin und von dieser weg verschiebbar sind.

4. Bohrvorrichtung nach einem oder mehreren der vorhergehenden Ansprüche, wobei die Bohrköpfe (8a, b) beide von der gleichen Betätigungseinrichtung (4) betätigt werden.

5. Bohrvorrichtung nach Anspruch 4, wobei die Betätigungseinrichtung (4) eine Linearbetätigungseinrichtung (6) mit einer Stange mit doppelten Auslegern umfasst, wobei jeder Stangenabschnitt (5a, b) auf den zugehörigen Bohrkopf (8a, b) einwirkt, so dass einer der Köpfe (8a, b) betätigt wird, um die Schneidbewegung auszuführen, und gleichzeitig der andere Kopf so betätigt wird, dass er die Rückzugsbewegung ausführt.

## Revendications

1. Dispositif de perçage de cartes de circuits imprimés (Pa, Pb) comprenant une première tête de perçage (8a) guidée le long d'un axe de perçage (Z) vers, et depuis, un premier plan de perçage correspondant ((XY)a) sensiblement perpendiculaire au dit axe de perçage (Z), ledit plan de perçage ((XY)a) étant apte à se déplacer par rapport au dit axe de perçage (Z) lorsque ladite première tête de perçage (8a) se déplace en s'éloignant dudit plan de perçage ((XY)a) durant un mouvement de positionnement de la carte devant être percée (Pa), ladite tête (8a) étant apte à se déplacer le long dudit axe (Z), vers ledit plan ( (XY) a) durant un mouvement de découpe, et depuis ledit plan ((XY)a) durant un mouvement opposé de retour, et comprenant par ailleurs une seconde tête de perçage (8b) rigide avec ladite première tête (8a) dans le mouvement le long dudit axe (Z) et un second plan de perçage ((XY)b) parallèle au dit premier plan et faisant face à ladite seconde tête de perçage (8b) dans une configuration telle qu'un mouvement de retour de ladite première tête (8a) correspond à un mouvement de découpe de ladite seconde tête (8b) et vice versa.

2. Dispositif de perçage selon la revendication 1, dans lequel lesdites têtes de perçage (8a, 8b) sont coaxiales.

3. Dispositif de perçage selon la revendication 1 ou 2, dans lequel, pour chaque tête de perçage, un dispositif de pressage de pièce à usiner (10) est prévu, lesdites têtes étant aptes à se déplacer vers, et depuis, le plan de perçage correspondant ((XY)a, b) indépendamment du dispositif de pressage de pièce à usiner respectif (10).

4. Dispositif de perçage selon une ou plusieurs des revendications précédentes, dans lequel lesdites têtes de perçage (8a, b) sont actionnées toutes les deux par le même actionneur (4).

5. Dispositif de perçage selon la revendication 4, dans lequel ledit actionneur (4) comprend un actionneur linéaire (6) pourvu d'une double tige saillante, chaque section de tige (5a, b) agissant sur la tête de perçage respective (8a, b) de sorte à actionner l'une desdites têtes (8a, b) pour lui commander d'exécuter le mouvement de découpe et, dans le même temps, de sorte à actionner l'autre tête pour lui commander d'exécuter le mouvement de retour.
